# EUROPEAN PATENT APPLICATION

(11) **EP 3 213 863 A1**
(43) Date of publication of application: **06.09.2017**
(21) Application number: 15856920.2
(22) Date of filing: 03.11.2015
(51) Int. Cl.: B23K 28/02, B23K 9/04, B23K 11/00, B23K 25/00

(54) **ELECTRIC MELTING METHOD FOR FORMING METAL STRUCTURE**

(30) Priority: 04.11.2014 CN 201410617953
(71) Applicant: Nanfang Additive Manufacturing Technology Co., Ltd, Foshan, Guangdong 528225 (CN)
(72) Inventor: WANG, Huaming, Foshan Guangdong 528225 (CN)
(74) Representative: Sun, Yiming
(86) International application number: PCT/CN2015/093636
(87) International publication number: WO 2016/070778

(57) **Abstract**

An electric melting method for forming metal components. The method provides an electric melting head (6) and a base material (2) being connected to the anode and the cathode of a power supply (12). During the forming of the component, the raw metal wire (1) is sent to the base material (2) via the feeder (5) and the electric melting head (6) to generate electric arc (9) between the raw wire (1) and the base material (2) under the protection of the deposition of granular auxiliary material (3). The electric arc melts a part of the deposited auxiliary material (3) and creates a molten slag pool (8). Electric current flows through the raw wire (1) and the molten slag pool (8), and generates the resistance heat and the electroslag heat. The raw wire (1) is molten under the high-energy heat resource composed of the electric arc heat, the resistance heat and the electroslag heat, and thereby creating a molten pool (11) on partial surface of the base material (2). The raw wire (1) and the auxiliary material (3) are fed continuously and a computer is employed to control the relative movement of the electric melting head (6) and the base material (2) based on laminated slicing data, such that the molten pool (11) is rapidly cooled, solidified and deposited on the base material (2), and thus the metal component with desired shape and size are formed after the layer-to-layer deposition.

## Description

### Technical Field

The present invention relates to electric melting methods for forming metal components.

### Background of the Invention

At present, modern heavy industrial equipment in fields of nuclear power, thermal power, petrochemical industry, metallurgy, shipbuilding etc. is increasingly rapidly developed towards the direction of large scale, complexity, high performance, as well as high reliability and long service life under extreme conditions. The dimension of the required key metal component such as the high-strength low-alloy steel, heat-resistance alloy or the like is becoming bigger and the quality requirement is becoming higher. In the dominated manufacturing methods, hundreds-ton great steel ingot is used for smelting and casting, and heavy forging equipment such as thousands-ton hydraulic press or the like for forge forming, and machining is followed at the last step for supplementation. Such methods may basically satisfy the quality requirement. However, the formed component may cost a lot due to the fact of complex manufacturing process steps, long production cycle, low material utilization ratio. On the other hand, complex process and great difficulty in controlling the chemical and mechanical performance also cause poor stability of quality and high defective index. Furthermore, confined by China's manufacturing capability in the present state, the special high-performance large-scale metal component still needs importing from Japanese companies like the Japan Steel Works and the Doosan Heavy Industries, etc., which hold a high price and has a strict export restrictions, thereby seriously impacting the progress of project constructions and limiting the development of China's heavy equipment manufacturing.

To solve above problems, China and its enterprises expect to make a great breakthrough on heavy equipment manufacturing. Opportunities and challenges coexist in the same. In recent years, the up-and-coming fused deposition rapid modeling (i.e.3D printing) is becoming a vital developing direction.

With the advantages of high flexibility in manufacturing, short prototyping cycle, and rapid processing, etc., 3D printing is widely applied in modeling/prototyping of molds of product module, for instance, low-melting point materials such as wax, resin and etc. are used to form/model the mold of a workpiece. Additionally, 3D printing has achieved great breakthrough and application in the manufacturing of titanium alloy metal component in specific industries like aerospace, yet there are still many difficulties to be overcome if the 3D printing is going to totally enter the manufacturing industry, especially the heavy equipment manufacturing industry. The difficulties include the selection of high-energy density heat source which could melt high-melting point metal element and the design and manufacturing of a completely new 3D system; the R&D and preparing of raw material (e.g. wire or powder);. how to overcome the crack, pore, chemical segregation, and performance requirement of total cross-section in the process of forming the complex structure of the large size heavy metal component; and how to ensure a stable and mature technology to equal or even beyond the traditional forging process, satisfying the higher and higher chemical and mechanical performance requirement of heavy metal component in all industries.

### Summary of the Invention

Accordingly, the main object of the present invention is to provide an electric melting method for forming metal components with high efficiency, low cost, and great mechanical properties.

To achieve the above object, in the present invention, the electric melting method adopts a high-energy heat source composed of electric arc heat, resistance heat, and electroslag heat to melt raw metal wire fed continually, and create a metal component by solidifying and depositing the molten raw metal wire on a base material layer by layer;
an electric melting head and a base material are connected to the anode and cathode of a power supply respectively; during the forming/modeling of the metal component, the raw metal wire is sent to a surface of the base material by a feeder and the electric melting head to electric arc is generate electric arc between the raw wire and the base material under the protection of the deposition of granular auxiliary material; wherein the electric arc melts a part of the deposited auxiliary material and creates a molten slag pool; an electric current flowing through the raw wire and the molten slag pool of auxiliary material generates resistance heat and electroslag heat; the raw wire is molten under the high-energy heat resource composed of the electric arc heat, resistance heat and electroslag heat, and thereby creates a molten pool on partial surface of the base material. The raw wire and the auxiliary material are fed continuously and a computer is employed to control the relative movement of the electric melting head and the base material based on a laminated slicing data, such that the molten pool is rapidly cooled, solidified and deposited on the base material, and therefore the metal component with desired shape and size are formed after the layer-to-layer deposition.

In the present invention, the electric current of the power supply may be 200A-6000A, the voltage of the power supply may be 20V-60V.The power supply may be a DC power supply or a AC power supply. When the DC power supply is employed, the electric melting head is connected to either the anode or the cathode of the power supply.

In the present invention, based on the dimension and shape of formed workpiece, the diameter of the raw wire may be ranged of 2 mm - 20 mm. Based on various diameter of the raw wire, the length extending out the electric melting (energization length) is ranged of 20 mm - 150 mm.

In the present invention, the overlaying thickness of the auxiliary material in the forming process is ranged of 15 mm - 120 mm. The auxiliary material includes oxide, or a combination oxide and halide, or a combination of oxide, halide and metal powder. According to the requirement of forming efficiency and metallic composition of the component, no more than 30% of alloy powder and/or metallic simple substance powder may be added into the auxiliary material.

The grannular auxiliary material reacts with the elements of the molten pool in the forming process, adjusting the alloy elements in the molten pool, improving the mechanical performance of the formed workpiece, and reducing the production cost.

In the present invention, the surface temperature of the base material or the deposited metal layer is ranged of 100 - 600°C, and the speed of relative movement between the electric melting head and the base material is ranged of 150 - 3000 mm/min, thereby facilitating the rapid solidification of the molten pool, and obtaining a material with fine grain size, non-macrosegregation and homogeneous structure, such that mechanical properties, for example, plasticity, toughness, and high-temperature creep, of the formed workpiece is greatly improved. Furthermore, the high-temperature molten pool performs heat treatment on the deposited metal layer of the heat-affected zone of the lower layer, and the workpiece is treated by self-tempering layer after layer, such that the obtained grain size is finer and its structure is more stable.

In the present invention, during the process of layer-by layer forming, a molten pool is formed on a surface of metal of a lower layer by the raw wire, in which the molten droplet enters the molten pool in the form of jet and solidifies therein, rendering the two metal layers to form together as an integral. As such, the layer-forming and integral fusion method ensures the overall performance of the formed metal component.

In the present invention, a single electric melting head has a melting efficiency ranged of 10 - 80 Kg/h for the raw wire. The height of the metal layers deposited due to the relative movement of the electric melting head and base material is ranged of 1 - 8mm. In addition, in order to improve the deposition efficiency and achieve rapid forming, the number of the electric melting head may be varied from 1 to 100 as desired. When multiple electric melting heads are arranged, the interval of the adjacent electric melting heads may be ranged of 50 - 500 mm.

In the present invention, the edge of the formed metal component may be supported and protected by the auxiliary material or metal substrate, preventing the molten metal from overflow. The dimension and shape of the base material are matched with the shape of the initially-deposited metal layer, and the thickness thereof no less than 5 mm is preferred. The base material and deposited metal may be of same or different material. The base material may be removed in the following machining process if the base material and the deposited metal are employing different material, whereas the base material may be kept as a part of the formed metal component if the base material is employing the same material as the deposited metal.

The present invention gets rid of the restrictions of complex works, molds and specialized tools. The formed component is a near net shape preform which needs few finishing process after production, leading to great simplification of the manufacturing procedures and reduction of the production cycle. The formed workpiece has mechanical and chemical performance better, at least not worse, than that made by the traditional forging process. The performance of the formed component including strength, toughness, corrosion resistance and the like are very excellent. The method provided by the present invention can be applied to the forming and producing of various heavy metal components for all industries, for example, low-alloy steel, heat-resistant steel, stainless steel, and nickel-based alloy material.

### Brief Description of the Drawings

Fig. 1A is a schematic diagram illustrating an electric melting method for forming a metal component according to one embodiment of the present invention.
Fig. 1B is a partial enlarging diagram of a neighboring region of point A in Fig. 1A.
Fig. 2 is a schematic diagram illustrating the forming method of Embodiment 1.
Fig. 3 is a schematic diagram illustrating the forming method of Embodiment 2.
Fig. 4 is a schematic diagram illustrating the forming method of Embodiment 3.
Fig. 5 is a schematic diagram illustrating the forming method of Embodiment 4.

### Detailed Description of the Invention

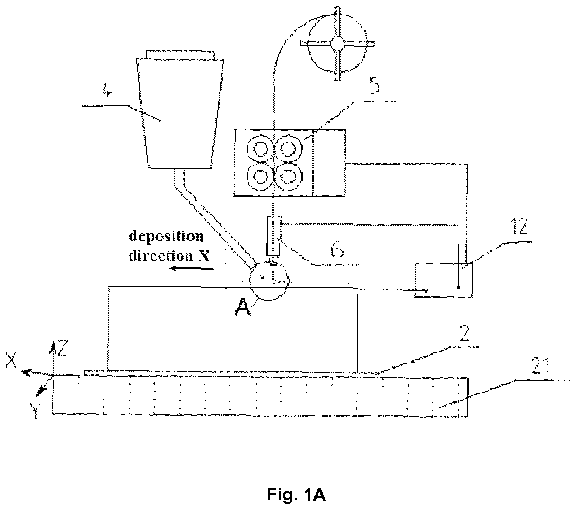

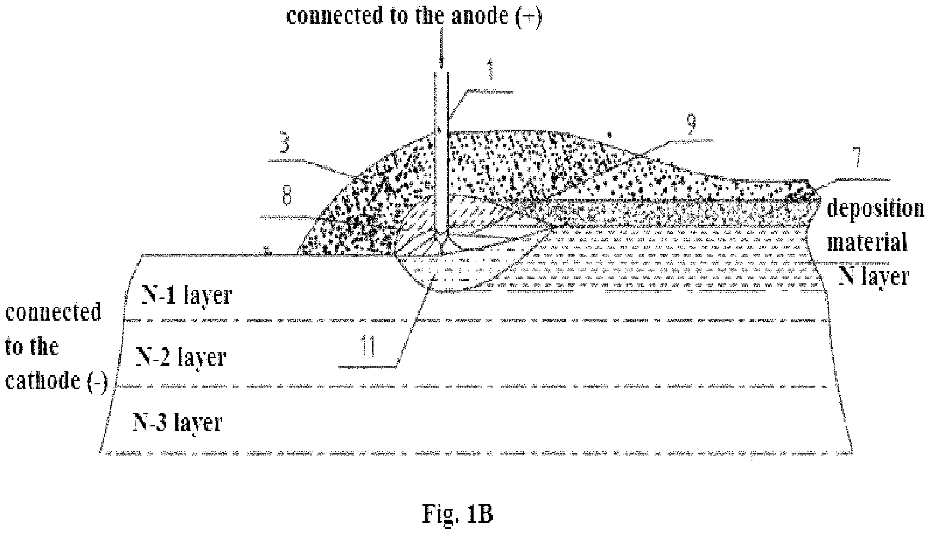

The embodiments of the present invention is illustrated with reference to the drawings. Fig. 1A is a schematic diagram illustrating an electric melting method for forming a metal component according to one embodiment of the present invention. Fig. 1B is a partial enlarging diagram of a neighboring region of point A in Fig. 1A. As for schematic drawings where the component is for schematic purpose, the actual shape and dimension etc. should not be limited by the illustration of the drawings.

In the forming method, the raw wire 1 is molten and deposited on the base material 2 layer by layer (Fig. 1 shows the state where N layers N has deposited), such that the desired metal component may be formed.

The specific implementing steps are as below.
A. wire feeder 5 delivers wire raw wire 1 to the surface of base material 2 which positioned on worktable 21, wherein the surface of the base material 2 is covered by granular auxiliary material delivered by powder feeder 4;
B. power supply 12 is initiated, and the voltage of the power supply 12 facilitates the generation of electric arc 9 between raw wire 1 and base material 2; wherein the electric arc heat melts a part of auxiliary material 3, and creates a slag pool 8 of auxiliary material; the electric current flows through the raw wire 1 via the electric melting head (fusion head) 6 to generate resistant heat, and flows through the molten slag pool 8 to generate electroslag heat; therefore, a high-energy heat source composed of the identified three heat resource melts the raw wire and creates a molten pool 11 on a surface of the base material 2;
C. the relative movement of electric melting head 6 and base material 2 and the temperature of base material 2 are controlled to achieve the heat exchanging, solidification, and deposition of molten pool 11 and base material;
D. wire feeder 5 and powder feeder 4 deliver the raw wire 1 and auxiliary material 3 continuously, under the situation where the molten pool 11 and base material 2 are covered by auxiliary material 3, raw wire 1 is deposited on the base material 2 layer by layer until the workpiece is formed.

A control device (computer) controls the way of the relative movement of the electric melting head 6 and base material 2 based on the laminated slicing data of the formed component o (numerical simulation, mathematical model).

In the figures of the present invention, the electric melting head is connected to the anode of the power supply while the workpiece is connected to the cathode. It is to be noted that such connection is only exemplary. In other embodiments, the electric melting head may be connected to the cathode of the power supply whereas the workpiece is connected to the anode. In some embodiments, AC power supply may be employed.

In the present invention, in order to make sure the forming of the high-energy heat source, especially to have sufficient electroslag heat, the parameters such as the composition of the auxiliary material, the diameter of the raw wire, the electric current, the speed of relative movement of the base material and the raw wire may be adjusted appropriately.

In the present invention, the raw wire 1 may be shaped as round bar, belt, solid cored or flux cored. The diameter of the raw wire 1 may be ranged of 2 - 20 mm according to the dimension of the formed workpiece. Based on the various diameter of wire material 1, the length extending out the electric melting head (energization length) may be ranged of 20 mm - 150 mm.

In the present invention, the overlaying thickness of the auxiliary material 3 is ranged of 15 mm - 120 mm. The use of auxiliary material 3 has the following advantages including: avoiding the splash of the electric arc 9 by covering the electric arc 9; protecting the metal of the molten pool from oxygen, nitrogen, hydrogen in the air by covering molten pool 11 and insulating the air; keeping the metal of the molten pool from losing temperature; removing impurities and doping alloys during the metallurgical reaction process; ensuring the excellent forming of the deposited metal 10 mechanically by the formed slag pool 8 (slag crust 7).

The composition of the auxiliary material 3 includes oxide or a combination of oxide and halide. The auxiliary material 3 is involved in the reaction of molten pool to adjust the composition of the workpiece (metal component, product), therefore the alloy powder and/or the metal simple substance powder may be added into the auxiliary material based on the composition requirement and efficiency requirement of the metal component to be formed, thereby reducing the production cost.

Moreover, step C may comprise a further step of recycling the residual auxiliary material and removing the slag crust 7 which is formed by the solidification of the slag pool 8. In the removing step, the removing operation may be carried out mechanically or manually from a position behind the wire with a distance of 400 mm - 500 mm.

The implementation of the electric melting forming method in the embodiments makes the utilization ratio of the raw wire approach 100%. Compared to the existing processing technology (e.g. forging, casting and the like), the present method has less manufacturing process (complex heat treatment is not more needed), shorter production cycle, higher efficiency. The formed metal component has very small machining allowance reducing the time on finish machining and saving lots of material.

### Embodiment 1

Horizontal manufacturing for a rotary cylinder. The present embodiment illustrates a manufacturing process of cylinder by a horizontal electric melting forming method, in which the material adopted is common low-carbon steel, and the equipment used includes:
(1) rotatable support platform; (2) power supply; (3) electric melting head; (4) automatic wire feeder; (5) automatic auxiliary material feeding and recycling device; (6) heater; (7) cooler; (8) base material; (9) control device (computer).

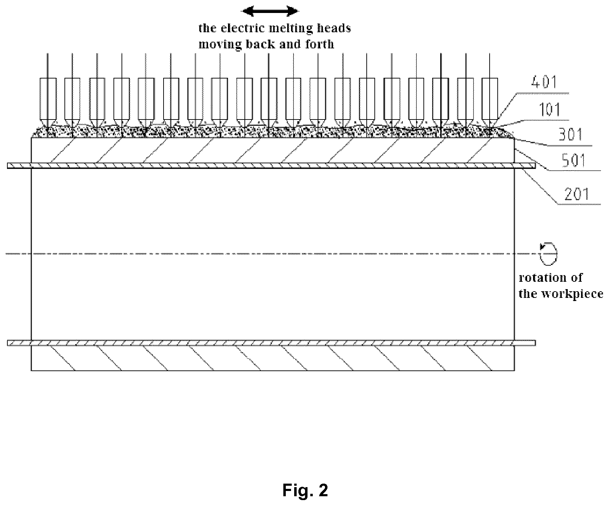

Fig. 2 is a schematic diagram illustrating the forming method of the present embodiment, in which the power supply, the automatic wire feeder and etc. are omitted for simplicity. As shown in Fig. 2, there are common low carbon steel with a diameter of 4 mm that is selected as the raw material 101; nineteen electric melting heads 401; DC power supply. In the figures, the electric melting heads are connected to the cathode of the power supply and the substrate is connected to the anode of the power supply (in the situation where DC power supply is employed, the manufacturing efficiency may be greatly improved with the electric melting heads being connected to the cathode of the power supply and the substrate being connected to the anode). The processing parameters of the electric melting are as follows: the electric melting current is of 700A, the electric melting voltage is of 35V, the speed of the relative movement of the electric melting head 401 and the base material 201 is of 500-600mm/min. When the electric melting method for forming a metal component is used to manufacture an annular metal component, the implementation steps is as below:
(1) the axis of cylindrical base material 201 is horizontally arranged, and being supported by the rotatable support platform; twenty electric melting heads 401 are evenly and horizontally arranged above the base material 201 with an interval (i.e., the distance between the centers of the adjacent raw wire) of 200 mm; the distance between each electric melting head 401 and the surface of the base material 201 (exterior surface) is properly adjusted, and the start point of electric melting is selected;
(2) when the raw wire 101 and the auxiliary material 301 are fed to the surface of the base material 201, the power supply is initiated to introduce the high-energy heat source; the high-energy heat source melts the raw wire 101 and the auxiliary material 301; at the same time, the base material 201 is rotated to start the electric melting deposition for the first pass of the first layer of each electric melting head (each of layers is constituted of multiple axially-arranged passes) of each electric melting head;
(3) after a distance between the electric melting head 401 and the start point of the electric melting is formed, the auxiliary material 301 recycling device is initiated to recycle the unmelted auxiliary material 301, such that the slag crust is exposed and being removed to facilitate the electric melting deposition (accumulation) for the pass; the cooler or the heater is subsequently initiated to cool or heat the electric melting deposited metal, such that the temperature of the base (which is referred to the base material 201 during the building of first layer and the former deposited metal layer during the building of other layers) is controlled at a range of 200-300°C;
(4) when the base material 201 is rotated one round and the electric melting deposition of the first pass is finished, all of the electric melting heads 401 are controlled by the control device to move towards the left by a distance of the three-quarter width of the melting pass, and at the same time the distance between each electric melting head 401 and the surface of base material 201 is adjusted to ensure the stability of the electric melting; afterward, the electric melting deposition for the second pass of the first layer is started; during this step, the left and the right passes should be well overlapped
(5) after the electric melting deposition of the second pass is finished, step (4) is repeated to finish the forming of the electric melting deposition for the remaining passes; when the electric melting head comes to the last pass, the end point of the last pass and the start point of first pass of the adjacent electric melting heads 401 should be well overlapped so as to finish the electric melting deposition of the first layer;
(6) after the electric melting deposition of the first layer is finished, all of the electric melting heads 401 are lifted by a height equal to the deposition thickness of one layer (namely, the layer thickness); when the electric melting deposition of the first pass of the second layer is started, the end point of electric melting head of the first layer is the start point of the first pass of the second layer so as to achieve the continuous deposition;
(7) after electric melting deposition of the first pass of the second layer is finished, all of the electric melting heads 401 are moved towards the right simultaneously by a distance of three-quarter width of the melting pass, and the distance between each electric melting head 401 and the base material is automatically adjusted at the same time to ensure the stability of the electric melting; then the electric melting deposition for the second pass of the second layer is started and the left and right pass of the second pass are well overlapped;
(8) after the electric melting deposition for the second pass of the second layer is finished, step (7) is repeated to finish the electric melting deposition for the remaining passes; when the electric melting head comes to the last pass, the end point of the last pass and the start point of the first pass of the adjacent electric melting heads 401 are required to be well overlapped until the electric melting deposition of second layer is finished;
(9) Steps (6)-(8) are repeated to finish the electric melting deposition for the reaming layers; during this step, the electric melting heads 401 of the adjacent electric melting deposition layer are moved in opposite directions, so that a complete metal component is formed by the continuous electric melting deposition.

In the present method, because multiple (nineteen) of electric melting heads 401 are arranged side by side and used to carry out the forming at the same time, the forming efficiency is greatly increased.

### Embodiment 2

Vertical manufacturing of a rotary object. An electric melting method for forming a metal component is used to vertically grow and prepare a cylindrical metal component, the equipment used in the embodiment including:
(1) rotatable support platform; (2) power supply; (3) electric melting head; (4) automatic wire feeder; (5) automatic auxiliary material feeding and recycling device; (6) auxiliary material baffling device; (7) heater; (8) cooler; (9) base material; (10) control device.

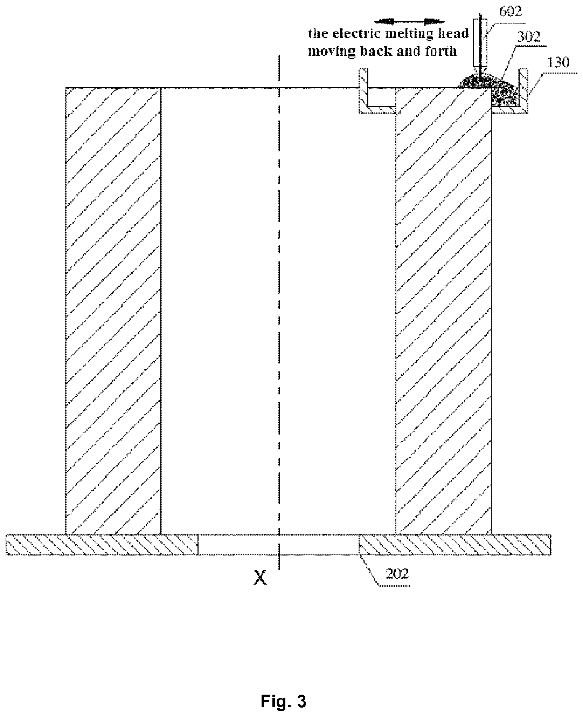

Fig. 3 is a schematic diagram illustrating the forming method of the embodiment, in which the rotatable support platform, the power supply and etc. are omitted for simplicity. As shown in Fig. 3, there are common low carbon steel with a diameter of 5 mm that is selected as the raw material; specialized auxiliary material; one electric melting head 602; DC power supply. In the figures, the electric melting head is connected to the anode of the power supply and the substrate 202 is connected to the cathode. The processing parameters of the electric melting are as follows: the electric melting current is of 900A, the electric melting voltage is of 36V, the speed of the relative movement of the electric melting head 602 and the substrate is of 600-700 mm/min; the base material 202 is flat and has the same material as the raw wire. When the electric melting method for forming a metal component is used to manufacture an annular metal component, the implementation steps is as below:
(1) the base material 202 is secured to the horizontally rotatable support platform, and the direction of the board is as aligned with the horizontal direction; a start point for the electric melting is selected on the base material 201, and the auxiliary material baffling device 302 is well installed to resist the auxiliary material on the edge of the component to be formed indirectly by the auxiliary material 302; the power supply, the wire feeder, and the auxiliary material feeding device are initiated at the same time, and then the rotatable support platform is initiated to enable the base material to be rotated in the horizontal plane with the X-axis being the center; thereby the electric melting deposition for the first pass of the first layer of is started;
(2) after a distance between the electric melting head 602 and the start point of the electric melting is formed, the auxiliary material 302 recycling device is initiated to recycle the unmelted auxiliary material 302, such that the slag crust is exposed and being removed to facilitate the electric melting deposition (accumulation) on the pass; the cooler or the heater is subsequently initiated to cool or heat the electric melting deposited metal, such that the temperature of the base (which is referred to the base material 201 during the building of first layer and the former deposited metal layer during the building of other layers) is controlled at a range of 200-300°C;
(3) after a first round, the electric melting deposition comes back to the start point, the electric melting deposition for the first pass of the first layer is finished; at the same time, the electric melting head 602 is started to move along its radial direction in a straight line; such that the electric melting head is moved inwardly to the annulus by a distance, and start electric melting deposition for the second pass of the first layer continuously; wherein the inner and outer pass are well overlapped;
(4) the radial and straight movement of the electric melting head 602 is combined with the rotation of the rotatable support platform, rendering the track of electric melting deposition of a single layer to be helical; after electric melting deposition for the second pass is finished, the step (4) is repeated to continuously finish the electric melting deposition for the remaining passes until the desired thickness (redial dimension) of the workpiece is achieved, and the electric melting deposition of the first layer is finally finished;
(5) after the electric melting deposition of the first layer is finished, electric melting head 602 is automatically lifted by a predetermined height, and the electric melting deposition for the first pass of the second layer is started; wherein the end point of the first layer is the start point of the second layer so as to achieve the continuous deposition;
(6) after the electric melting deposition for the first pass of the second layer is finished, the electric melting head 602 is moved outwardly along the redial direction in a straight line by a distance and the electric melting deposition for the second pass of the second layer is started, wherein the inner and outer pass are well overlapped;
(7) after the electric melting deposition for the second pass of the second layer is finished, step (7) is repeated to finish the electric melting deposition of the remaining passes until required thickness of the workpiece is achieved, and therefore the electric melting deposition of the second layer is finished;
(8) steps (5)-(7) are repeated to finish the electric melting deposition for the remaining layers so that a complete metal component is formed; during the manufacturing processes of the metal component, the electric melting head 602 in the adjacent electric melting deposition layers are moved in opposite directions and the auxiliary material baffling device is lifted as the increasing of the electric melting deposition, such that a workpiece is finally formed.

During the forming process, in addition to the vertical forming process, the auxiliary material baffling device 130 which is lifted as the increasing of the formed deposited metal increasing is employed to support (undertake) the auxiliary material 302 so that the auxiliary material 302 is filled (baffled) at the outer side of the metal component, and therefore preventing the molten metal from overflow during the forming process.

### Embodiment 3

The manufacturing of the irregularly shaped workpiece. Common low-carbon steel H08A is selected as the raw wire and an electric melting method for forming metal components is used to vertically grow and manufacture a metal component with end socket by vertical growing. The apparatus used in the embodiment including:
(1) rotatable support platform; (2) power supply; (3) electric melting head; (4) automatic wire feeder; (5) automatic auxiliary material feeding device and automatic auxiliary material recycling device; (6) auxiliary material baffling device; (7) heater; (8) cooler; (9) base material; (10) control device.

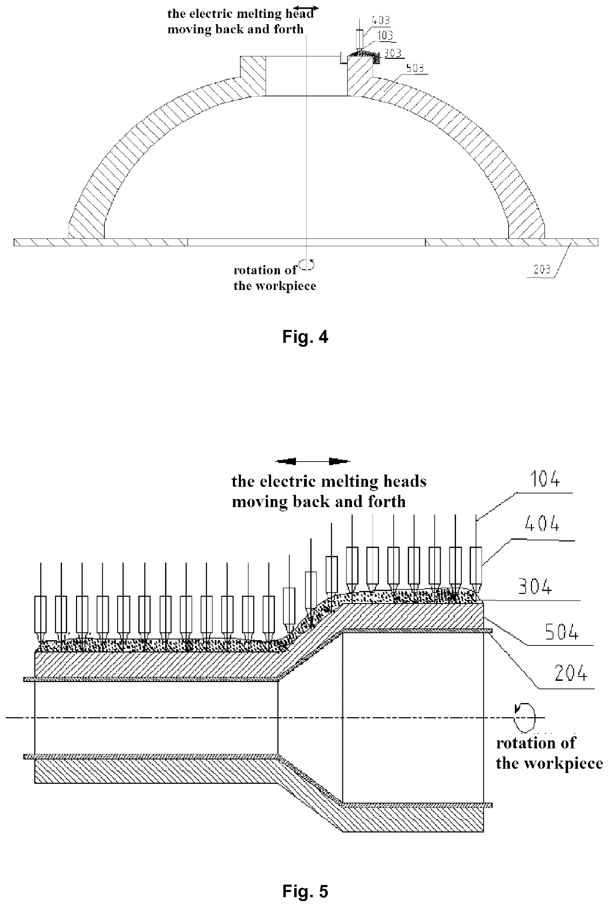

Fig. 4 is a schematic illustration of the electric melting method in the present embodiment, for simplicity, the apparatus are omitted in the Fig.. The selected parameters are as follows: the diameter of the wire bar is of 5mm; the auxiliary material has 30% of Iron powder is adding into a standard fused flux SJ101; the electric melting current is of 900A, the electric melting voltage is of 40V, electric melting head 403 is connected to the anode of the power supply and the substrate 203 is connected to the cathode; the speed for feeding the wire is of 2200 mm/min; the linear speed of the rotation is of 750 mm.

The implementation steps is as below:
(1) the base material 203 is secured on the rotatable supporting platform, and a start point of the electric melting deposition is selected; the auxiliary material feeding device is initiated to deliver the auxiliary material 303, and therefore starting the deposition for the first pass of the first layer;
(2) after the raw wire 103 is deposited on the first pass by a distance, which is generally ranged of 400-500mm from the electric melting head, the auxiliary material 303 recycling device is initiated to recycle the unmelted auxiliary material 303 and the process of removing the slag crust is started at the same time; then the cooler is initiated to carry out the process of cooling, and controlling the temperature between the passes within a range of 150-300°C for the electric melting deposition of the next pass;
(3) after electric melting deposition of the first pass is done, the electric melting head 403 is immediately moved slowly outside-in ; cooperating with the rotatable supporting platform, the electric melting head 403 carries out the electric melting deposition on the base board in a horizontally helical track, as shown in Fig. 4, until the deposition reaches the thickness of the component;
(4) when the electric melting head 403 comes to the last point of the helical track, the helical movement is stopped, and a circle movement (which ensures the roundness of the workpiece) is started to carry out the electric melting deposition, such that the electric melting deposition of the first layer is finished;
(5) when the electric melting deposition of the first layer is finished, an automatically height-adjusting system of the electric melting head 403 detects the distance between the electric melting head 403 and the deposited metal, compares the detected distance with a predetermined value, and adjust the height of electric melting head 403 automatically, and at the same time control the electric melting head 403 to move outwardly from inside to outside, such that an outwardly helical moving track is formed and the electric melting deposition for the next layer gets started;
(6) steps (1)-(5) are repeated to complete the electric melting deposition for the second layer;
(7) repeating above steps, wherein the electric melting head 403 of the odd layers is moved outside-in, and the electric melting head 403 of the even layers is moved inside-out to carry out the electric melting deposition layer by layer, such that a complete heavy metal component 305 is obtained.

In the present embodiment, the electric melting method is used to form a irregularly shaped workpiece(end socket). Because 30% iron powder is introduced during the production, the forming efficiency is greatly improved.

### Embodiment 4

The integral formation of a cylinder of an evaporator. The present embodiment illustrates an electric melting method for integrally forming a cylinder of a nuclear power evaporator. In the traditional forging process, the whole cylinder may be divided into six sections (two upper sections, three lower sections, and one cone section). The six sections are forged respectively first, and then being assembly welded. The material of the cylinder is low-alloy steel SA508Gr3CL2. After the cylinder is formed, the inner wall of which needs build-up welding with the 308 stainless steel having a thickness of about 8 mm. By using the method provided in the present invention, the cylinder can be integrally formed in a single time. The apparatus used by the present method includes:
(1) rotatable support platform; (2) power supply; (3) electric melting head; (4) automatic wire feeder; (5) automatic auxiliary material feeding device and automatic auxiliary material recycling device; (6) auxiliary material baffling device; (7) heater; (8) cooler; (9) base material; (10) control device.

Fig. 5 is a schematic illustration of the electric melting method according to the present embodiment, in which the power supply, the automatic wire feeder and etc. are omitted for simplicity. As shown in Fig. 2, there are specialized low carbon steel with a diameter of 5 mm that is selected as the raw wire 104 (C: 0.11-0.12%; other elements is consistent with SA508-3); specialized auxiliary material (compositions of which are 29.5% CaO+MgO; 30% Al₂O_{3_} +MnO; 20.5% SiO₂+TiO; 20% CaF₂); twenty one electric melting heads 404; DC power supply. In the figures, the electric melting heads 404 are connected to the cathode of the power supply and the base material 201 is connected to the anode. The process parameters are as follows: the electric melting current is of 900A, the electric melting voltage is of 42V, and the speed of the relative movement of the electric melting heads 404 and the base material 204 is of 600-700 mm/min; the base material 204 is a formed cylinder of 308 stainless steel. The electric melting method for forming metal components is employed to manufacture an annular metal component, the implementation steps are as follows:
(1) the axis of cylindrical base material 204 is horizontally arranged, and being supported by the rotatable support platform; twenty electric melting heads are evenly and horizontally arranged above the base material 204 with an interval of 200 mm (i.e., the distance between the centers of the adjacent raw wire); the distance between each electric melting head 401 and the surface of the base material 204 (exterior surface) is properly adjusted, and the start point of electric melting is selected;
(2) when the raw wire 104 and the auxiliary material are fed to the surface of the base material 204, the power supply is initiated to introduce the high-energy heat source; the high-energy heat source melts the raw wire and the auxiliary material; at the same time, the base material 204 is rotated to start the electric melting deposition for the first pass of the first layer of each electric melting head (each of layers is constituted of multiple axially-arranged passes) of each electric melting head;
(3) after a distance between the electric melting head 404 and the start point of the electric melting is formed, the auxiliary material 304 recycling device is initiated to recycle the unmelted auxiliary material 301, such that the slag crust is exposed and being removed to facilitate the electric melting deposition (accumulation) for the pass; the cooler or the heater is subsequently initiated to cool or heat the electric melting deposited metal, such that the temperature of the base (which is referred to the base material 201 during the building of first layer and the former deposited metal layer during the building of other layers) is controlled at a range of 200-300°C;
(4) when the base material 204 is rotated one round and the electric melting deposition of the first pass is finished, all of the electric melting heads 404 are controlled by the control device to move towards the left by a distance of the three-quarter width of the melting pass, and at the same time the distance between each electric melting head 404 and the surface of base material 204 is adjusted to ensure the stability of the electric melting; afterward, the electric melting deposition for the second pass of the first layer is started; during this step, the left and the right passes should be well overlapped
(5) after the electric melting deposition of the second pass is finished, step (4) is repeated to finish the forming of the electric melting deposition of the remaining passes; when the electric melting head comes to the last pass, the end point of the last pass and the start point of first pass of the adjacent electric melting heads 404 should be well overlapped so as to finish the electric melting deposition of the first layer;
(6) after the electric melting deposition of the first layer is finished, all of the electric melting heads 404 are lifted by a height equal to the deposition thickness of one layer (namely, the layer thickness); when the electric melting deposition of the first pass of the second layer is started, the end point of electric melting head of the first layer is the start point of the first pass of the second layer so as to achieve the continuous deposition;
(7) after electric melting deposition of the first pass of the second layer is finished, all of the electric melting heads 404 are moved towards the right simultaneously by a distance of three-quarter width of the melting pass, and the distance between each electric melting head 404 and the base material is automatically adjusted at the same time to ensure the stability of the electric melting; then the electric melting deposition for the second pass of the second layer is started and the left and right pass of the second pass are well overlapped;
(8) after the electric melting deposition for the second pass of the second layer is finished, step (7) is repeated to finish the electric melting deposition for the remaining passes; when the electric melting head comes to the last pass, the end point of the last pass and the start point of the first pass of the adjacent electric melting heads 404 are required to be well overlapped until the electric melting deposition of second layer is finished;
(9) Steps (6)-(8) are repeated to finish the electric melting deposition for the reaming layers; during this step, the electric melting heads 404 of the adjacent electric melting deposition layer are moved in opposite directions, so that a complete metal component is formed by the continuous electric melting deposition.

In the present method, the base material 204 of stainless steel becomes a part of the cylinder of the container, such that different materials are used to form the cylinder directly that changes the traditional process which forges SA508-3 cylinder first and build-up welds the 308 stainless steel on the inner wall. Moreover, because multiple (twenty one) of electric melting heads are used and arranged side by side, the traditional process that carries out forging in sections first and build-up welding afterwards is changed. As such, the process and procedure are simplified and the working efficiency and quality are improved.

## Claims

1. An electric melting method for forming an metal component, **characterized in that**
providing a high-energy heat source composed of electric arc heat, resistance heat, and electroslag heat to melt a raw metal wire which is fed continually, and create a metal component by solidifying and depositing the molten raw metal wire on a base material layer by layer;
providing an electric melting head and a base material being connected to the anode and cathode of a power supply respectively; wherein, during the forming of the metal component, the raw metal wire is sent to a surface of a base material by a feeder and the electric melting head to generate the electric arc between the raw wire and the base material under the protection of the deposition of granular auxiliary material, wherein the electric arc melts a part of the deposited auxiliary material and creates a molten slag pool; an electric current flows through the raw wire and the molten slag pool of auxiliary material and generates the resistance heat and the electroslag heat; wherein the raw wire is molten under the high-energy heat resource composed of the electric arc heat, the resistance heat and the electroslag heat, and thereby creating a molten pool on partial surface of the base material; wherein the raw wire and the auxiliary material are fed continuously and a computer is employed to control the relative movement of the electric melting head and the base material based on laminated slicing data, such that the molten pool is rapidly cooled, solidified and deposited on the base material, and thus the metal component with desired shape and size are formed after the layer-to-layer deposition.

2. The electric melting method according to claim 1, **characterized in that**
the raw wire is made of low-alloy metal, heat-resistance steel, stainless steel or nickel-based alloy with a diameter of 2 mm - 20 mm.

3. The electric melting method according to claim 1, **characterized in that**
the auxiliary material is granular, composed of metallic oxide, a combination of metallic oxide and halide, or a combination of metallic oxide, halide and metal powder, wherein the auxiliary material is overlaid on the molten pool with a thickness of 15 mm - 120 mm; no more than 30% alloy powder and/or metal simple substance powder is added into the auxiliary material to improve the production efficiency.

4. The electric melting method according to claim 1, **characterized in that**
the power supply is a DC (direct current) power supply or a AC (alternate current) power supply; when the DC power supply is employed, the electric melting head which powers the raw wire is connected to either anode or cathode of the power supply; the electric current is ranged of 200A-6000A and the electric voltage is of 20V - 60V based on different diameters of the raw wire.

5. The electric melting method according to claim 1, **characterized in that**
based on different current/voltage parameters, a speed of the relative movement between the electric melting head and the base material is ranged of 150 - 3000 mm/min, a melting efficiency of single electric melting head is ranged of 5 - 80 Kg/h, and a height of single deposition layer is ranged of 1 - 8 mm.

6. The electric melting method according to claim 1, **characterized in that**
based on the material requirement and dimension requirement of the formed component, the base material or the deposited metal is heated or cooled, such that the surface temperature of the base material or the deposited metal layer is control at a range of 100 - 600°C.

7. The electric melting method according to claim 1, **characterized in that**
based on the dimension requirement, shape requirement and efficiency requirement of the formed metal component, the number of the electric melting head is adjustable at a range of 1 - 100; when more than one electric melting head are used, the electric melting heads are arranged with an interval of 50 - 500 mm.

8. The electric melting method according to claim 1, **characterized in that**
the base material provides work support for the forming of the component, wherein the dimension and shape of the base material is designed according to the deposited metal, wherein the thickness thereof is not less than 5 mm.

9. The electric melting method according to claim 1, **characterized in that**
based on various production requirement, the base material is made of either identical or distinct material to the deposited metal; after the metal deposition is done, the base material is kept as a part of the formed component or removed by following machining.

10. The electric melting method according to claim 1, **characterized in that**
based on various diameter of the raw wire, an energization length, which is the length of the raw wire extending out the electric melting head is ranged of 20 mm - 150 mm.
